# FASCICULE DE BREVET EUROPEEN

(11) **EP 3 864 687 B1**
(45) Date de publication et mention de la délivrance du brevet: **23.11.2022**
(21) Numéro de dépôt: 19786570.2
(22) Date de dépôt: 10.10.2019
(51) Int. Cl.: H01L 21/20, H01L 21/78

(54) **PROCÉDÉ DE TRANSFERT DE FILM MINCE**
VERFAHREN ZUR ÜBERTRAGUNG VON DÜNNSCHICHTEN
METHOD FOR TRANSFERRING THIN FILMS

(30) Priorité: 12.10.2018 FR 1859456
(43) Date de publication de la demande: 18.08.2021
(73) Titulaire: Commissariat à l'Energie Atomique et aux Energies Alternatives, 75015 Paris (FR)
(72) Inventeur: FOURNEL, Frank, 38054 GRENOBLE CEDEX 9 (FR); MICHAUD, Laurent, 38054 GRENOBLE Cedex 9 (FR); MONTMEAT, Pierre, 38054 GRENOBLE CEDEX 9 (FR)
(74) Mandataire: Hautier IP
(86) Numéro de dépôt international: PCT/EP2019/077513
(87) Numéro de publication internationale: WO 2020/074658

(56) Documents cités:
- WO-A1-2013/050683
- WO-A1-2015/084868
- WO-A1-2018/104513

## Description

### DOMAINE TECHNIQUE DE L'INVENTION

L'invention concerne le domaine des microtechnologies et de la microélectronique. Elle trouve pour application particulièrement avantageuse le transfert d'un film mince semiconducteur sur un substrat flexible.

### ÉTAT DE LA TECHNIQUE

Dans le domaine de la microélectronique, un moyen de générer une contrainte mécanique dans une couche mince d'un matériau semiconducteur est de transférer cette couche mince sur un substrat flexible, puis de déformer le substrat flexible.

En déformant le substrat flexible dans un plan d'extension principale de la couche mince, il est ainsi possible de soumettre la couche mince à un état de tension biaxiale, par exemple.

La couche mince peut être issue d'un substrat de type « Silicium sur Isolant » (SOI pour l'acronyme anglais « Silicon On Insulator »). Elle peut correspondre en particulier à la couche supérieure en silicium, dénommée top Si, de ce substrat SOI.

Le transfert de la couche mince sur le substrat flexible est une phase critique.

Le document « Transfer of Ultra-Thin Semi-Conductor Films onto flexible substrates, Montméat et al., 2017 » divulgue un procédé de transfert de couche mince sur substrat flexible, comprenant un premier collage en face avant du SOI sur un substrat porteur, un rognage et des gravures en face arrière du SOI afin d'exposer le top Si, et un deuxième collage du top Si exposé sur le substrat flexible. Après retrait du substrat porteur, une couche mince de Si sur un substrat flexible est ainsi obtenue.

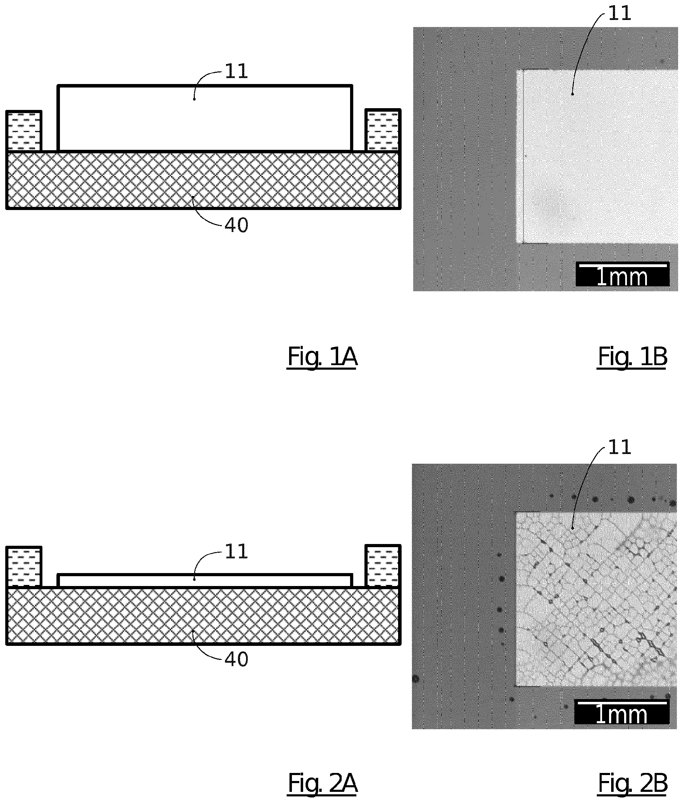

Comme illustré aux figures 1A et 1B, un tel procédé permet de transférer un top Si 11 monocristallin de 200 nm d'épaisseur sur un substrat flexible 40 sans générer de fissures (figure 1B).

Pour un nombre d'applications croissant, il serait cependant préférable de transférer une couche mince de Si présentant une épaisseur inférieure à 200 nm.

Par exemple, les travaux du demandeur montrent que le procédé mentionné cidessus ne permet pas de transférer un top Si monocristallin de 20 nm d'épaisseur sur un substrat flexible de façon satisfaisante (figure 2A). Pour une telle épaisseur, des fissures apparaissent après transfert, tel qu'illustré en figure 2B.

En particulier, ce procédé utilise la couche intermédiaire en oxyde de silicium du substrat SOI, dénommée BOX (acronyme anglais « Burried OXide »), comme couche d'arrêt pour la gravure face arrière.

Cette couche d'arrêt doit être suffisamment épaisse pour éviter la gravure du top Si, et suffisamment mince pour éviter l'apparition des fissures.

Une telle couche d'arrêt est cependant incompatible avec le procédé décrit cidessus.

Un objet de la présente invention est de pallier au moins en partie ces inconvénients.

On connaît par ailleurs, de la publication brevet WO 2018/104513 A1, un procédé de transfert de couches minces utilisant un empilement avec une couche d'interface en matériau polymère. Par ailleurs, on connaît de la publication brevet WO 2013/050683 A1 un procédé de report de couches utilisant un substrat donneur et un substrat receveur, via un substrat intermédiaire, avec des étapes de collage spécifiques.

En particulier, un objet de la présente invention est de proposer un procédé de transfert de couche permettant de transférer une couche mince d'un matériau semiconducteur sur un substrat flexible sans générer de fissures dans la couche mince, notamment pour une épaisseur de couche mince inférieure à 200 nm.

### RÉSUMÉ DE L'INVENTION

Pour atteindre cet objectif, la présente invention prévoit un procédé de transfert de couche comprenant les étapes suivantes :
- fournir un premier substrat présentant une face avant et une face arrière et comprenant un support formant la face arrière et un empilement sur le support, ledit empilement comprenant une première couche en un premier matériau, semiconducteur, formant la face avant, et une deuxième couche en un deuxième matériau, diélectrique,
- fournir un deuxième substrat présentant une face libre et comprenant une couche en un matériau polymère formant la face libre,
- coller les premier et deuxième substrats au niveau d'une interface entre la face avant du premier substrat et la face libre du deuxième substrat,
- retirer le support puis la deuxième couche du premier substrat, de sorte à exposer la première couche collée sur la couche en un matériau polymère.

Dans cette invention, le premier substrat est formé avec au moins un empilement supplémentaire comprenant une troisième couche en un troisième matériau et une quatrième couche en un quatrième matériau, ledit au moins un empilement supplémentaire étant intercalé entre le support et l'empilement du premier substrat, de sorte que la quatrième couche soit du côté du support et que la troisième couche soit du côté de la deuxième couche de l'empilement.

Le procédé comprend en outre au moins une étape supplémentaire configurée pour retirer la quatrième couche puis la troisième couche, puis la deuxième couche.

La quatrième couche est retirée par une gravure présentant une sélectivité vis-à-vis du troisième matériau supérieure à 5, puis la troisième couche est retirée par une gravure présentant une sélectivité vis-à-vis du deuxième matériau supérieure à 5, puis la deuxième couche est retirée par une gravure présentant une sélectivité vis-à-vis du premier matériau supérieure à 5.

Le recours à un tel empilement supplémentaire permet de contrôler plus progressivement et plus finement la façon dont les différentes couches sont retirées.

En particulier, cet empilement supplémentaire constitue une zone tampon ou une zone de transition vers la couche d'arrêt.

Cet empilement supplémentaire peut être vu comme un empilement d'arrêt, multicouches.

Il permet de protéger la première couche, dite couche supérieure.

Il permet en outre de relâcher une partie des contraintes mécaniques de la couche supérieure.

Les différentes couches de cet empilement supplémentaire peuvent en effet absorber ou emmagasiner en partie les contraintes mécaniques de la couche supérieure.

Lors du retrait de ces différentes couches, la relaxation des contraintes, principalement au niveau des surfaces libres, se fait de façon progressive, ce qui évite *in fine* l'apparition de fissures dans la couche supérieure.

Cet empilement supplémentaire comprenant au moins deux couches de nature différente permet également un meilleur contrôle du retrait de ces différentes couches.

Le procédé proposé par la présente invention permet ainsi d'éviter un retrait ou une gravure trop rapide de la deuxième couche, dite couche d'arrêt.

Cet empilement supplémentaire rend le procédé proposé par la présente invention compatible avec une couche d'arrêt de faible épaisseur, typiquement une couche d'arrêt présentant une épaisseur de l'ordre de 40 nm ou 50 nm.

Le procédé selon l'invention permet dès lors, par exemple pour une couche d'arrêt de 40 nm environ, de transférer une couche supérieure de 20 nm environ ou moins sur une couche en un matériau polymère d'un substrat flexible sans générer de fissures dans ladite couche supérieure.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
- La FIGURE 1A schématise en coupe transverse une couche supérieure de 200 nm d'épaisseur environ sur un substrat flexible obtenue par un procédé de transfert selon l'art antérieur ;
- La FIGURE 1B montre en vue de dessus une couche supérieure en Si de 200 nm d'épaisseur environ sur un substrat flexible obtenue par le procédé de transfert selon l'art antérieur illustré à la figure 1A ;
- La FIGURE 2A schématise en coupe transverse une couche supérieure de 20 nm d'épaisseur environ sur un substrat flexible obtenue par un procédé de transfert selon l'art antérieur ;
- La FIGURE 2B montre en vue de dessus une couche supérieure en Si de 20 nm d'épaisseur environ sur un substrat flexible obtenue par le procédé de transfert selon l'art antérieur illustré à la figure 2A ;
- La FIGURE 3A illustre en coupe transverse un substrat comprenant un empilement supplémentaire selon un mode de réalisation de l'invention ;
- La FIGURE 3B illustre en coupe transverse un substrat comprenant un empilement supplémentaire selon un autre mode de réalisation de l'invention ;
- Les FIGURES 4 à 10B illustrent en coupe transverse des étapes du procédé de transfert selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et plaques ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
- Selon un mode de réalisation, le procédé comprend en outre une deuxième étape de transfert après que la deuxième couche du premier substrat soit retirée, cette deuxième étape comprenant la fourniture d'un substrat flexible et le collage de ce substrat flexible sur une face exposée de la première couche, opposée à la face avant, puis une séparation, par exemple par arrachement mécanique, de la première couche et de la couche en un matériau polymère de sorte à exposer la face avant de la première couche collée sur le substrat flexible.
- Selon un mode de réalisation, l'épaisseur de la première couche est choisie strictement inférieure à l'épaisseur de la troisième couche.
- Selon un mode de réalisation, l'épaisseur de la deuxième couche est choisie strictement inférieure à l'épaisseur de la quatrième couche.
- Selon un mode de réalisation, l'épaisseur de la première couche est choisie au moins deux fois inférieure à l'épaisseur de la troisième couche.
- Selon un mode de réalisation, l'épaisseur de la deuxième couche est choisie au moins deux fois inférieure à l'épaisseur de la quatrième couche.
- Selon un mode de réalisation, l'épaisseur de la première couche est choisie strictement inférieure à l'épaisseur de la deuxième couche.
- Selon un mode de réalisation, l'épaisseur de la troisième couche est choisie strictement inférieure à l'épaisseur de la quatrième couche.
- Selon un mode de réalisation, l'épaisseur de la première couche est choisie au moins deux fois inférieure à l'épaisseur de la deuxième couche.
- Selon un mode de réalisation, l'épaisseur de la troisième couche est choisie au moins deux fois inférieure à l'épaisseur de la quatrième couche.
- Selon un mode de réalisation, le support est partiellement retiré par rognage sur au moins 90%, et de préférence sur au moins 95%, de son épaisseur.
- Selon un mode de réalisation, le support est partiellement retiré par rognage, ledit rognage étant configuré pour laisser une couche résiduelle du support présentant une épaisseur résiduelle inférieure ou égale à 50 µm.
- Selon un mode de réalisation, la couche résiduelle est retirée par une première gravure présentant une sélectivité vis-à-vis du quatrième matériau supérieure à 5.
- Selon un mode de réalisation, la première gravure et la troisième gravure sont des gravures en solution présentant une même composition, de préférence à base d'un mélange d'acide acétique/d'acide nitrique HNO3 70%/ d'acide fluorhydrique HF, et de préférence à base d'un mélange d'acide acétique/HNO3 concentré à 70%/HF concentré à 49% en proportion 3/3/4.
- Selon un mode de réalisation, la deuxième gravure et la quatrième gravure sont des gravures en solution présentant une même composition, de préférence à base d'acide fluorhydrique HF, par exemple à base d'HF dilué à 10%.
- Selon un mode de réalisation, l'épaisseur de la deuxième couche est inférieure ou égale à 100 nm, de préférence inférieure ou égale à 50 nm.
- Selon un mode de réalisation, l'épaisseur de la première couche est inférieure à 100 nm, de préférence inférieure ou égale à 50 nm.
- Selon un mode de réalisation, le matériau polymère est un matériau thermoplastique.
- Selon un mode de réalisation, les premier et troisième matériaux sont au moins l'un parmi du silicium, du germanium et un alliage de silicium-Germanium
- Selon un mode de réalisation, les deuxième et quatrième matériaux sont au moins l'un parmi un oxyde de silicium et un nitrure de silicium.
- Selon un mode de réalisation, le support est en silicium et les premier et troisième matériaux sont seulement du silicium.
- Selon un mode de réalisation, les deuxième et quatrième matériaux sont seulement un oxyde de silicium.

Il est précisé que, dans le cadre de la présente invention, le rognage se fait de préférence par meulage. Le meulage est un procédé d'enlèvement ou d'amincissement généralement purement mécanique.

Le meulage consiste à abraser un matériau par frottement avec des grains ou des particules coupantes agglomérées par un liant au moins en surface d'un outil. En particulier, une roue diamantée mise en rotation sur une meule permet d'effectuer un tel usinage par abrasion.

Le meulage peut être assisté par un flux d'eau de manière à limiter un échauffement des matériaux en frottement, et/ou de manière à charrier, par une action physique, des particules de matériau abrasé.

Le meulage, dans le cadre de la présente invention, peut être mis en oeuvre avec l'ajout d'abrasif libre, ou de solution de gravure chimique.

Dans la suite, les termes « rognage », « meulage » et « usinage par abrasion » sont synonymes.

Alternativement ou en combinaison, le rognage peut également comprendre un procédé de polissage mécano-chimique (CMP pour l'acronyme anglais « Chemical-Mechanical Polishing ») combinant des actions chimiques et mécaniques, en mélangeant généralement un abrasif libre à une solution de gravure humide.

Dans le cadre de la présente invention, la gravure se fait de préférence par voie humide. Il n'est cependant pas exclu que certaines étapes, voire toutes les étapes de gravure puissent se faire par voie sèche, par exemple par des gravures de type RIE (acronyme anglais de « Reactive Ion Etching ») ou plasma (par exemple ICP « Inductively Coupled Plasma » ou CCP « Capacitively Coupled Plasma »).

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

On entend par un film, une couche, « à base » d'un matériau A, un film, une couche comprenant ce matériau A uniquement ou ce matériau A et éventuellement d'autres matériaux, par exemple des éléments d'alliage, des impuretés ou des éléments dopants.

On entend par une interface entre une couche A et une couche B une zone intercalaire entre ces deux couches A et B. Cette zone intercalaire peut être la zone de formation du contact, ou peut comprendre une couche C, par exemple une couche antiadhésive.

Dans la présente demande de brevet, l'épaisseur est prise selon une direction perpendiculaire aux faces principales des couches. Sur les figures en coupe transverse, l'épaisseur est prise selon la verticale.

Les termes « sensiblement », « environ », « de l'ordre de » signifient en tenant compte des tolérances de fabrication et/ou de mesure et peut notamment correspondre « à 10% près ».

Le procédé de transfert selon l'invention va maintenant être décrit en référence aux figures annexées à la présente demande.

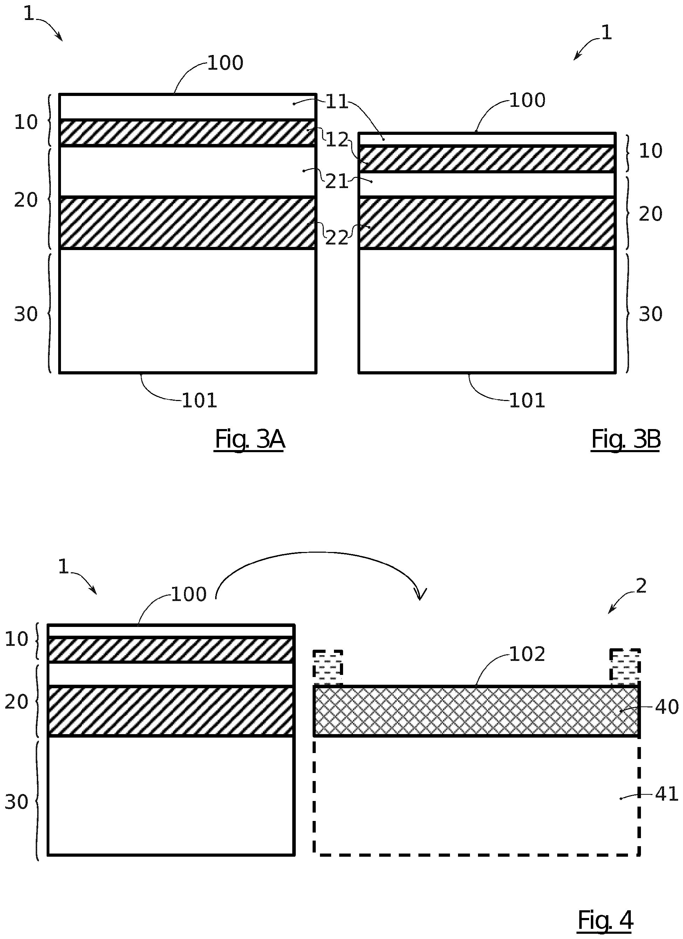

Comme illustré aux figures 3A et 3B, le principe de l'invention est de préparer de façon spécifique avant transfert un substrat 1 comprenant une couche à transférer 11 formant un empilement 10 avec une couche d'arrêt 12. Cet empilement 10, également dénommé empilement terminal ou encore empilement supérieur, est sur une couche 30 massive.

La couche à transférer 11 est dénommée couche supérieure 11. La couche d'arrêt 12 est également dénommée couche d'arrêt terminale.

L'empilement terminal 10 peut donc être constitué de deux couches. Il forme dès lors un bicouche 10.

Selon une possibilité, l'empilement 10 peut comprendre trois couches ou plus.

La préparation spécifique du substrat 1 consiste à former au moins un empilement 20 supplémentaire intercalé entre l'empilement terminal 10 et la couche 30 massive.

Cet empilement 20 supplémentaire comprend de préférence deux couches 21, 22. Il forme dès lors un bicouche 20. Selon une possibilité, l'empilement 20 supplémentaire peut comprendre trois couches ou plus.

Cet empilement 20 supplémentaire forme ainsi une zone tampon entre la couche 30 massive et la couche d'arrêt 12 de l'empilement 10.

Cette zone tampon permet avantageusement d'améliorer le contrôle des gravures destinées à retirer la couche d'arrêt 12 et à conserver la couche à transférer 11.

L'empilement 20 supplémentaire est donc un empilement d'arrêt, multicouches.

Le substrat 1 peut comprendre une pluralité de bicouches 20 intercalés entre la couche 30 et le bicouche 10.

Les épaisseurs de chacune des couches au sein de chaque bicouche 10, 20 sont de préférence décroissantes depuis la face arrière 101 vers la face avant 100.

Les épaisseurs de chaque bicouche 10, 20 sont de préférence décroissantes depuis la face arrière 101 vers la face avant 100.

Avantageusement, les bicouches 10, 20 sont de même nature et/ou composition chimique.

En particulier, le bicouche 10 peut comprendre une couche à transférer 11 en un matériau semiconducteur et une couche d'arrêt 12 en un matériau diélectrique, et le bicouche 20 peut comprendre une couche 21 en ce même matériau semiconducteur et une couche 22 en ce même matériau diélectrique.

Cela simplifie avantageusement les étapes technologiques du procédé de transfert. Cela simplifie en particulier les étapes de formation des bicouches 10, 20, et les étapes de gravure de ces bicouches 10, 20.

Les couches, de préférence en un matériau diélectrique et les couches de préférence en un matériau semiconducteur de deux bicouches 10, 20 adjacents sont de préférence alternées.

L'épaisseur du bicouche 10 est avantageusement strictement inférieure à l'épaisseur du bicouche 20, de préférence d'un facteur cinq, voire d'un facteur dix.

Selon un exemple illustré à la figure 3A, la couche à transférer 11 est au moins deux fois moins épaisse que la couche 21 du bicouche 20. La couche à d'arrêt 12 est au moins deux fois moins épaisse que la couche 22 du bicouche 20.

Selon un exemple illustré à la figure 3B, la couche 21 du bicouche 20 est au moins deux fois moins épaisse que la couche 22 du bicouche 20. La couche à transférer 11 est au moins deux fois moins épaisse que la couche d'arrêt 12.

Le rapport entre les épaisseurs de la couche en un matériau semiconducteur et de la couche en un matériau diélectrique au sein d'un bicouche 10, 20 peut donc être sensiblement égal à 2. Ce rapport est de préférence compris entre 1 et 3.

Les modes de réalisation de ces exemples peuvent être combinés. Les épaisseurs des différents bicouches 10, 20 sont choisies avantageusement de manière à pouvoir transférer une couche à transférer 11 mince, c'est-à-dire présentant une épaisseur inférieure à 200 nm, par exemple comprise entre 20 nm et 50 nm.

Par exemple, le bicouche 10 peut présenter une épaisseur comprise entre 50 nm et 200 nm, et le bicouche 20 peut présenter une épaisseur comprise entre 500 nm et 2 µm.

Le bicouche 20 d'arrêt est ainsi suffisamment épais pour protéger le bicouche 10 terminal lors de la gravure visant à exposer la couche à transférer 11.

Un tel substrat 1 comprenant entre sa face arrière 101 et sa face avant 100 successivement une couche 30 massive, le bicouche 20 d'arrêt épais et le bicouche 10 terminal fin, permet avantageusement une progressivité des étapes de retrait et/ou de gravure depuis la face arrière 101 vers la face avant 100 visant à exposer la couche à transférer 11.

Les épaisseurs de chacune des couches du substrat 1 sont de préférence décroissantes depuis la face arrière 101 vers la face avant 100.

En référence aux figures 4 à 10, le procédé de transfert selon l'invention prévoit une étape de collage de la face avant 100 du substrat 1 sur la face libre 102 d'une couche 40 en un matériau polymère, dite couche polymère, d'un deuxième substrat (figure 4).

De façon optionnelle, une couche antiadhésive peut être déposée sur la face avant 100 de la couche à transférer 11, avant mise en contact du substrat 1 et de la couche 40 respectivement au niveau de la face avant 100 et de la face libre 102.

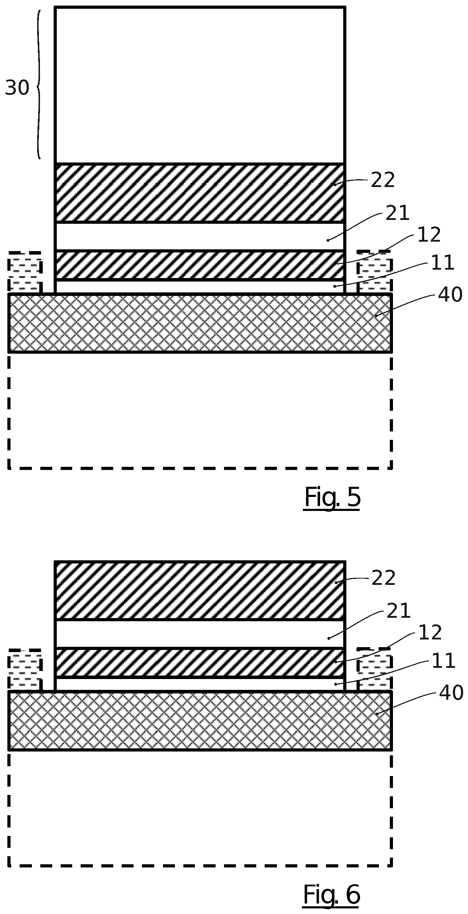

La couche à transférer 11 est dès lors au contact de ou en interface avec la couche polymère 40 (figure 5).

Les étapes suivantes du procédé de transfert consistent à retirer successivement, à partir de la face arrière 101 du substrat 1, d'abord la couche 30 massive, puis la couche 22, puis la couche 21, et ensuite la couche d'arrêt 12 afin d'exposer la couche à transférer 11.

Le retrait de la couche 30 massive se fait principalement par rognage. L'abrasion mécanique permet de retirer rapidement la majeure partie de la couche 30 massive, sur au moins 90% de son épaisseur. Le rognage peut être configuré pour laisser une épaisseur résiduelle de couche 30 d'environ 25 µm ou avantageusement 50µm. Une gravure d'appoint permet de retirer la couche 30 sur toute l'épaisseur résiduelle. Cette gravure d'appoint est configurée pour s'arrêter dans la couche 22, de préférence au niveau de l'interface entre la couche 30 massive et la couche 22 (figure 6). En particulier, la sélectivité de la gravure d'appoint du matériau de la couche 30 massive vis-à-vis du matériau de la couche 22 est de préférence supérieure à 10, et de préférence supérieure à 100. La couche 30 massive est ainsi totalement retirée.

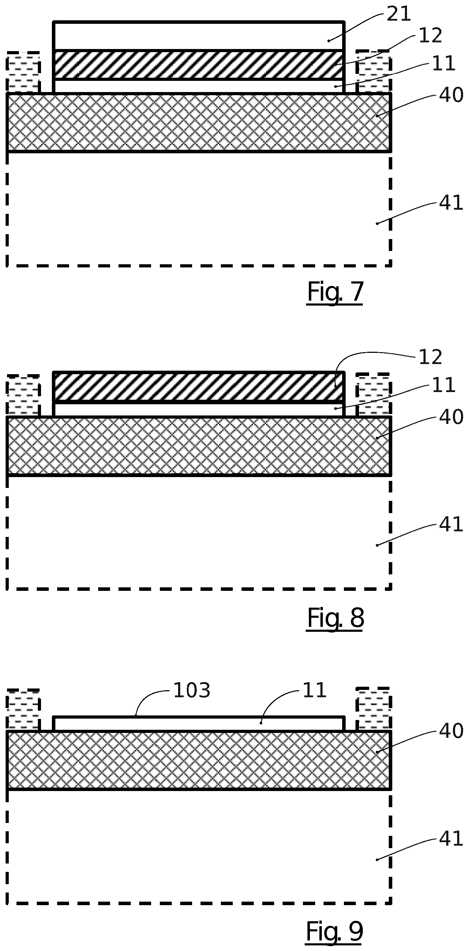

La couche 22 est ensuite retirée par une première gravure (figure 7).

Cette première gravure est configurée pour s'arrêter dans la couche 21, de préférence au niveau de l'interface entre la couche 22 et la couche 21. Elle présente une sélectivité de gravure vis-à-vis du matériau de la couche 21 de préférence supérieure à 10, et de préférence supérieure à 100.

La couche 21 est ensuite retirée par une deuxième gravure (figure 8).

Avantageusement, la couche 21 et la couche 30 massive sont composées du même matériau.

Dès lors, la solution de gravure de la gravure d'appoint peut être à nouveau mise en oeuvre de façon à retirer la couche 21 par cette deuxième gravure.

La deuxième gravure est configurée pour s'arrêter dans la couche d'arrêt 12, de préférence au niveau de l'interface entre la couche 21 et la couche d'arrêt 12. Elle présente une sélectivité de gravure vis-à-vis du matériau de la couche d'arrêt 12 de préférence supérieure à 10, et de préférence supérieure à 100.

La couche d'arrêt 12 est ensuite retirée par gravure (figure 9).

Avantageusement, la couche 22 est composée du même matériau que la couche d'arrêt 12, et la couche 21 est composée du même matériau que la couche à transférer 11.

Dès lors, la solution de gravure de la première gravure peut être à nouveau mise en oeuvre de façon à retirer la couche d'arrêt 12.

Cette gravure de la couche d'arrêt 12 est configurée pour s'arrêter sensiblement au niveau de l'interface entre la couche d'arrêt 12 et la couche à transférer 11. Une face 103 de la couche à transférer 11, opposée à la face avant 100, est ainsi exposée. Cette face est simplement dénommée « face opposée 103 » dans la suite.

La couche à transférer 11 est ainsi reportée sur la couche polymère 40 du deuxième substrat.

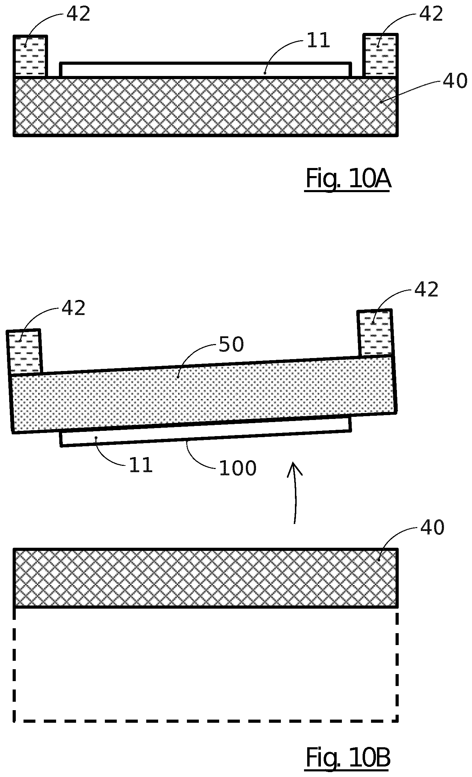

De façon optionnelle la couche polymère 40 surmontée de la couche supérieure 11 peut ensuite être séparée du substrat porteur 41 et/ou maintenue par un anneau de structure 42 (figure 10A). Alternativement, la face exposée de la couche supérieure 11 peut être mise en contact et/ou collée sur un autre substrat flexible 50, puis séparée de la couche polymère 40, par exemple par arrachement mécanique (figure 10B). Dans ce dernier cas, la face avant 100 de la couche supérieure 11 est de nouveau exposée.

Cela permet avantageusement d'obtenir une couche supérieure 11 sur un substrat flexible 50 présentant l'état de surface initial de la face avant 100. L'état de surface de la face avant 100, généralement obtenu par CMP, peut être d'une qualité supérieure à l'état de surface de la face opposée 103 obtenu par gravure de la couche d'arrêt 12.

Le procédé de transfert permet ainsi de transférer une couche à transférer 11 sur une couche polymère 40 par l'intermédiaire d'un retrait progressif et contrôlé des différentes couches 30, 22, 21, 12.

Avantageusement, la couche 30 massive est en un matériau semiconducteur et les bicouches 10, 20 présentent toutes respectivement une couche 11, 21 en ce même matériau semiconducteur alternée avec une couche 12, 22 en un même matériau diélectrique.

Cela permet de mettre en oeuvre uniquement deux solutions de gravure pour graver alternativement les couches 30, 21 en matériau semiconducteur et les couches 12, 22 en matériau diélectrique.

Le matériau semiconducteur peut être à base de silicium ou de germanium ou d'AIN ou d'AsGa ou d'InP. Le matériau diélectrique peut être à base d'oxyde de silicium ou de nitrure de silicium ou de carbone amorphe ou de TiN ou de TaN

Les étapes de gravure successives de ce procédé sont ainsi simplifiées.

Selon une possibilité, d'autres solutions de gravure peuvent être utilisées alternativement ou en combinaison. Par exemple, un troisième type de gravure peut être utilisé pour la gravure des couches les plus fines, de façon à diminuer la vitesse de gravure si nécessaire.

Selon un premier mode de réalisation, le substrat 1 est de préférence de type SOI (acronyme de « Silicon On Insulator » signifiant silicium sur isolant; mais des matériaux autres que le silicium sont aussi possibles). Les procédés d'obtention d'un substrat SOI sont connus. Ces procédés sont généralement utilisés pour obtenir un bicouche sur substrat massif. Ils permettent également d'obtenir un deuxième bicouche sur un premier bicouche. Ces procédés ne sont pas l'objet de la présente invention.

La couche à transférer 11 est en silicium, également dénommée top Si (signifiant silicium supérieur) dans la suite. Elle présente de préférence une épaisseur comprise entre 10 nm et 100 nm, par exemple de l'ordre de 20 nm.

La couche d'arrêt 12 est en dioxyde de silicium, également dénommée BOX (acronyme de « Burried Oxide » signifiant oxyde enterré). Elle présente de préférence une épaisseur comprise entre 30 nm et 200 nm, par exemple de l'ordre de 40 nm.

La couche 21 est en silicium. Elle présente de préférence une épaisseur comprise entre 50 nm et 200 nm, par exemple de l'ordre de 100 nm.

La couche 22 est en dioxyde de silicium. Elle présente de préférence une épaisseur comprise entre 200 nm et 600 nm, par exemple de l'ordre de 400 nm.

La couche 30 est en silicium. Elle présente typiquement une épaisseur de plusieurs centaines de µm et peut être également dénommée Si bulk (signifiant silicium massif) dans la suite.

Ce substrat 1 peut présenter un diamètre de 200 mm ou 300 mm.

La face avant 100 de ce substrat 1 peut être préalablement préparée par une étape de préparation de surface.

Selon une possibilité, une couche d'antiadhésif 3M^{™} Novec^{™} 2072 est déposée sur cette face avant 100, par exemple par centrifugation.

Cette couche antiadhésive facilite avantageusement un retrait ultérieur de la couche à transférer 11, en particulier un retrait par arrachement mécanique.

Une couche 40 présentant une épaisseur de 40µm environ de polymère BrewerBOND^{®} 305 est de préférence déposée par centrifugation sur une plaque 41 de silicium pour former le deuxième substrat 2.

La face avant 100 du substrat 1 et la face libre 102 du deuxième substrat 2 sont tournées en regard l'une de l'autre et mises en contact.

Les substrats 1, 2 sont ensuite collés à 210°C sous vide.

Un rognage, ou meulage, de la couche 30 de silicium est effectué.

Ce meulage est configuré pour enlever rapidement une majeure partie de l'épaisseur de la couche 30, par exemple avec un taux d'enlèvement compris entre 10 µm.min⁻¹ et 100 µm.min⁻¹.

Cette étape de meulage est par exemple réalisée par une meule de marque Okamoto^{®}, modèle 254B 3W5X J 75BA 325 40SB8, avec une roue diamantée présentant une taille de grain 16000/325 µm.

Le meulage de de la couche 30 peut être arrêté de façon à laisser une épaisseur résiduelle de silicium par exemple de 50 µm environ.

L'épaisseur résiduelle de silicium est ensuite retirée par gravure humide.

Une solution chimique à base d'acide acétique/HNO3 70%/HF 49% en proportion 3/3/4 permet avantageusement de retirer ces 50 µm en quelques minutes (par exemple moins de 10 minutes, voire moins de 5 minutes et avantageusement moins de 3 minutes).

Une telle solution est plus efficace qu'une solution de gravure standard à base de TMAH à 25 % effectuée à une température de 80 °C. Retirer 50 µm de silicium par la solution de gravure standard TMAH 25% à 80°C nécessite environ 5 heures d'attaque en immersion. La couche 40 de polymère BrewerBOND^{®} 305 épaisse de 40 µm ne peut pas supporter une attaque aussi longue.

La couche 22 d'oxyde de silicium est ensuite retirée par gravure humide avec une solution typique de HF 50%.

La couche 21 de silicium épaisse est ensuite retirée par la gravure en solution d'acide acétique/HNO3 70%/HF 49%, en immersion pendant un temps très court, par exemple de moins de 2 secondes et de préférence de l'ordre de la seconde, de sorte à arrêter la gravure dans la fine couche d'arrêt 12 d'oxyde de silicium.

La couche d'arrêt 12 (BOX) est ensuite retirée par gravure humide avec une solution typique de HF 10%.

A l'issue de cette étape de gravure, la face opposée 103 de la fine couche supérieure 11 (top Si) de silicium est exposée (figure 9).

Selon une possibilité préférée, un film polymère 50 maintenu par un anneau métallique de découpe 42 est collé sur la face opposée 103 du top Si 11.

Le deuxième substrat 2 est ensuite retiré par arrachement mécanique, de sorte à ne conserver que le top Si 11 sur le film polymère 50, avec la face avant 100 libre (figure 10B).

D'autres modes de réalisation du procédé selon l'invention peuvent être envisagés. Seules les caractéristiques distinctes du premier mode de réalisation sont décrites ci-après, les autres caractéristiques non décrites étant réputées identiques à celles du premier mode de réalisation.

Selon un deuxième mode de réalisation, l'épaisseur résiduelle de silicium après rognage de la couche 30, par exemple de l'ordre de 50 µm, est retirée, cela peut se faire par gravure humide notamment à base d'acide acétique/HNO3 70%/HF 49% en proportion 3/3/4 comme dans le premier mode de réalisation.

La couche 22 d'oxyde de silicium est ensuite retirée par gravure humide avec une solution typique de HF 10 %.

La couche 21 de silicium épaisse est ensuite retirée par une gravure en solution cette fois à base de TMAH à 12 % effectuée à une température de 80 °C, pendant un temps de quelques minutes, par exemple moins de 10 minutes, voire moins de 5 minutes, de préférence moins de 3 minutes, de sorte à arrêter la gravure dans la fine couche d'arrêt 12 d'oxyde de silicium. Avec un temps aussi court, le polymère 40 résiste à l'attaque chimique.

Cette gravure présente une vitesse de gravure inférieure à celle de la gravure à base d'acide acétique/HNO3 70%/HF 49% en proportion 3/3/4. Par conséquent, la tolérance sur le temps de gravure est plus grande. La mise en oeuvre de cette étape est facilitée. Par ailleurs, la sélectivité de cette gravure entre le silicium et l'oxyde de silicium S_{Si/SiO2} est supérieure à 500 :1. Cela permet avantageusement de préserver l'intégrité de la couche d'arrêt 12.

La couche d'arrêt 12 (BOX) est ensuite retirée par gravure humide avec une solution typique de HF 10%.

A l'issue de cette étape de gravure, la face opposée 103 de la fine couche supérieure 11 (top Si) de silicium est exposée (figure 9).

Selon une possibilité préférée, un film polymère 50 maintenu par un anneau métallique de découpe 42 est collé sur la face opposée 103 du top Si 11.

Le deuxième substrat 2 est ensuite retiré par arrachement mécanique, de sorte à ne conserver que le top Si 11 sur le film polymère 50, avec la face avant 100 libre (figure 10B).

L'invention n'est pas limitée aux modes de réalisations précédemment décrits et s'étend à tous les modes de réalisation couverts par les revendications.

Par exemple, certaines étapes de gravure peuvent être effectuées par voie sèche. Les couches les plus épaisses de l'empilement supplémentaires peuvent être retirées de façon mécano-chimique.

## Revendications

1. Procédé de transfert de couche comprenant les étapes suivantes :
- fournir un premier substrat (1) présentant une face avant (100) et une face arrière (101) et comprenant un support (30) formant la face arrière (101) et un empilement (10) sur le support (30), ledit empilement (10) comprenant une première couche (11) en un premier matériau, semiconducteur, formant la face avant (100), et une deuxième couche (12) en un deuxième matériau, diélectrique,
- fournir un deuxième substrat (2) présentant une face libre (102) et comprenant une couche en un matériau polymère (40) formant la face libre (102),
- coller les premier et deuxième substrats (1, 2) au niveau d'une interface entre la face avant (100) du premier substrat (1) et la face libre (102) du deuxième substrat (2),
- retirer le support (30) puis la deuxième couche (12) du premier substrat (1), de sorte à exposer la première couche (11) collée sur la couche en un matériau polymère (40),
et dans lequel le premier substrat (1) est formé avec au moins un empilement supplémentaire (20) comprenant une troisième couche (21) en un troisième matériau et une quatrième couche (22) en un quatrième matériau, ledit au moins un empilement supplémentaire (20) étant intercalé entre le support (30) et l'empilement (10) du premier substrat (1), de sorte que la quatrième couche (22) soit du côté du support (30) et que la troisième couche (21) soit du côté de la deuxième couche (12) de l'empilement (10),
le procédé étant **caractérisé en ce que** :
- il comprend en outre au moins une étape supplémentaire configurée pour retirer la quatrième couche (22) puis la troisième couche (21), puis la deuxième couche (12) ;
- la quatrième couche (22) est retirée par une gravure présentant une sélectivité vis-à-vis du troisième matériau supérieure à 5, puis
- la troisième couche (21) est retirée par une gravure présentant une sélectivité vis-à-vis du deuxième matériau supérieure à 5, puis
- la deuxième couche (12) est retirée par une gravure présentant une sélectivité vis-à-vis du premier matériau supérieure à 5.

2. Procédé selon la revendication précédente, dans lequel l'épaisseur de la première couche (11) est choisie strictement inférieure à l'épaisseur de la troisième couche (21), et dans lequel l'épaisseur de la deuxième couche (12) est choisie strictement inférieure à l'épaisseur de la quatrième couche (22).

3. Procédé selon l'une quelconque des revendications précédentes, dans lequel l'épaisseur de la première couche (11) est choisie strictement inférieure à l'épaisseur de la deuxième couche (12), et dans lequel l'épaisseur de la troisième couche (21) est choisie strictement inférieure à l'épaisseur de la quatrième couche (22).

4. Procédé selon la revendication 1, dans lequel l'épaisseur de la première couche (11) est choisie strictement inférieure à l'épaisseur de la troisième couche (21), et dans lequel l'épaisseur de la deuxième couche (12) est choisie strictement inférieure à l'épaisseur de la quatrième couche (22), et dans lequel l'épaisseur de la première couche (11) est choisie strictement inférieure à l'épaisseur de la deuxième couche (12), et dans lequel l'épaisseur de la troisième couche (21) est choisie strictement inférieure à l'épaisseur de la quatrième couche (22).

5. Procédé selon l'une quelconque des revendications précédentes dans lequel le support (30) est partiellement retiré par rognage, ledit rognage étant configuré pour laisser une couche résiduelle du support (30) présentant une épaisseur résiduelle inférieure ou égale à 50 µm.

6. Procédé selon la revendication précédente, dans lequel la couche résiduelle est retirée par une première gravure présentant une sélectivité vis-à-vis du quatrième matériau supérieure à 5.

7. Procédé selon la revendication précédente, dans lequel la première gravure et la gravure de la troisième couche (21) sont des gravures en solution présentant une même composition.

8. Procédé selon l'une quelconque des revendications précédentes, dans lequel la gravure de la quatrième couche (22) et la gravure de la deuxième couche (12) sont des gravures en solution présentant une même composition.

9. Procédé selon l'une quelconque des revendications précédentes, dans lequel l'épaisseur de la deuxième couche (12) est inférieure ou égale à 100 nm.

10. Procédé selon l'une quelconque des revendications précédentes dans lequel l'épaisseur de la première couche (11) est inférieure à 50 nm.

11. Procédé selon l'une quelconque des revendications précédentes dans lequel le matériau polymère est un matériau thermoplastique et/ou les premier et troisième matériaux sont au moins l'un parmi du silicium, du germanium et un alliage de silicium-Germanium, et/ou les deuxième et quatrième matériaux sont au moins l'un parmi un oxyde de silicium et un nitrure de silicium.

12. Procédé selon l'une quelconque des revendications précédentes dans lequel le support (30) est en silicium, les premier et troisième matériaux sont seulement du silicium et les deuxième et quatrième matériaux sont seulement un oxyde de silicium.

## Patentansprüche

1. Verfahren zur Übertragung von Schichten, das die folgenden Schritte umfasst:
- Bereitstellen eines ersten Substrats (1), das eine Vorderfläche (100) und eine Rückseitenfläche (101) aufweist und einen Träger (30) umfasst, der die Rückseitenfläche (101) bildet, sowie eine Stapelung (10) auf dem Träger (30), wobei die Stapelung (10) eine erste Schicht (11) aus einem ersten Halbleitermaterial umfasst, die die Vorderfläche(100) bildet, und eine zweite Schicht (12) aus einem zweiten, dielektrischen Material,
- Bereitstellen eines zweiten Substrats (2), das eine freie Fläche (102) aufweist und eine Schicht aus einem Polymermaterial (40), das die freie Fläche (102) bildet, umfasst,
- Kleben des ersten und des zweiten Substrats (1, 2) auf der Ebene einer Schnittfläche zwischen der Vorderfläche (100) des ersten Substrats (1) und der freien Fläche (102) des zweiten Substrats (2),
- Entfernen des Trägers (30), dann der zweiten Schicht (12) des ersten Substrats (1) derart, dass die erste Schicht (11), die auf die Schicht aus einem Polymermaterial (40) geklebt ist, freigelegt wird,
und wobei das erste Substrat (1) mit mindestens einer zusätzlichen Stapelung (20) gebildet wird, die eine dritte Schicht (21) aus einem dritten Material und eine vierte Schicht (22) aus einem vierten Material umfasst, wobei die mindestens eine zusätzliche Stapelung (20) zwischen dem Träger (30) und der Stapelung (10) des ersten Substrats (1) derart eingefügt wird, dass sich die vierte Schicht (22) auf der Seite des Trägers (30) befindet, und dass sich die dritte Schicht (21) auf der Seite der zweiten Schicht (12) der Stapelung (10) befindet, Verfahren **dadurch gekennzeichnet, dass**:
- es außerdem mindestens einen zusätzlichen Schritt umfasst, der dazu konfiguriert ist, die vierte Schicht (22), dann die dritte Schicht (21), dann die zweite Schicht (12) zu entfernen;
- die vierte Schicht (22) durch eine Gravur entfernt wird, die eine Selektivität höher als 5 gegenüber dem dritten Material aufweist, dann
- die dritte Schicht (21) durch eine Gravur entfernt wird, die eine Selektivität höher als 5 gegenüber dem zweiten Material aufweist, dann
- die zweite Schicht (12) durch eine Gravur entfernt wird, die eine Selektivität höher als 5 gegenüber dem ersten Material aufweist.

2. Verfahren nach dem vorstehenden Anspruch, wobei die Dicke der ersten Schicht (11) strikt kleiner als die Dicke der dritten Schicht (21) ausgewählt wird, und wobei die Dicke der zweiten Schicht (12) strikt kleiner als die Dicke der vierten Schicht (22) ausgewählt wird.

3. Verfahren nach einem der vorstehenden Ansprüche, wobei die Dicke der ersten Schicht (11) strikt kleiner als die Dicke der zweiten Schicht (12) ausgewählt wird, und wobei die Dicke der dritten Schicht (21) strikt kleiner als die Dicke der vierten Schicht (22) ausgewählt wird.

4. Verfahren nach Anspruch 1, wobei die Dicke der ersten Schicht (11) strikt kleiner als die Dicke der dritten Schicht (21) ausgewählt wird, und wobei die Dicke der zweiten Schicht (12) strikt kleiner als die Dicke der vierten Schicht (22) ausgewählt wird, und wobei die Dicke der ersten Schicht (11) strikt kleiner als die Dicke der zweiten Schicht (12) ausgewählt wird, und wobei die Dicke der dritten Schicht (21) strikt kleiner als die Dicke der vierten Schicht (22) ausgewählt wird.

5. Verfahren nach einem der vorstehenden Ansprüche, wobei der Träger (30) teilweise durch Beschneiden entfernt wird, wobei das Beschneiden dazu konfiguriert ist, eine Restschicht des Trägers (30), die eine Restdicke kleiner oder gleich als 50 µm aufweist, zu hinterlassen.

6. Verfahren nach dem vorstehenden Anspruch, wobei die Restschicht durch eine erste Gravur entfernt wird, die eine Selektivität höher als 5 gegenüber dem vierten Material aufweist.

7. Verfahren nach dem vorstehenden Anspruch, wobei die erste Gravur und die Gravur der dritten Schicht (21) Gravuren in Lösung, die dieselbe Zusammensetzung aufweist, sind.

8. Verfahren nach einem der vorstehenden Ansprüche, wobei die Gravur der vierten Schicht (22) und die Gravur der zweiten Schicht (12) Gravuren in Lösung, die dieselbe Zusammensetzung aufweist, sind.

9. Verfahren nach einem der vorstehenden Ansprüche, wobei die Dicke der zweiten Schicht (12) kleiner oder gleich 100 nm ist.

10. Verfahren nach einem der vorstehenden Ansprüche, wobei die Dicke der ersten Schicht (11) kleiner als 50 nm ist.

11. Verfahren nach einem der vorstehenden Ansprüche, wobei das Polymermaterial ein thermoplastisches Material ist, und/oder das erste und das dritte Material mindestens eines aus Silizium, Germanium und einer Silizium-Germanium-Legierung sind, und/oder das zweite und das vierte Material mindestens eines aus Siliziumoxid und Siliziumnitrid sind.

12. Verfahren nach einem der vorstehenden Ansprüche, wobei der Träger (30) aus Silizium besteht, das erste und das dritte Material nur Silizium sind, und das zweite und das vierte Material nur ein Siliziumoxid sind.

## Claims

1. Method for transferring a layer comprising the following steps:
- providing a first substrate (1) having a front face (100) and a rear face (101) and comprising a support (30) forming the rear face (101) and a stack (10) on the support (30), said stack (10) comprising a first layer (11) made of a first semiconductive material, forming the front face (100) and a second layer (12) made of a second dielectric material,
- providing a second substate (2) having a free face (102) and comprising a layer made of a polymer material (40) forming the free face (102),
- gluing the first and second substrates (1, 2) to an interface between the front face (100) of the first substrate (1) and the free face (102) of the second substrate (2),
- removing the support (30) then the second layer (12) of the first substrate (1), so as to expose the first layer (11) glued on the layer made of a polymer material (40), and wherein the first substrate (1) is formed with at least one additional stack (20) comprising a third layer (21) made of a third material and a fourth layer (22) made of a fourth material, said at least one additional stack (20) being interleaved between the support (30) and the stack (10) of the first substate (1), such that the fourth layer (22) is on the side of the support (30) and that the third layer (21) is on the side of the second layer (12) of the stack (10),
the method being **characterised in that**:
- it further comprises at least one additional step configured to remove the fourth layer (22) then the third layer (21), then the second layer (12);
- the fourth layer (22) is removed by an etching having a selectivity regarding the third material greater than 5, then
- the third layer (21) is removed by an etching having a selectivity regarding the second material greater than 5, then
- the second layer (12) is removed by an etching having a selectivity regarding the first material greater than 5.

2. Method according to the preceding claim, wherein the thickness of the first layer (11) is chosen strictly less than the thickness of the third layer (21), and wherein the thickness of the second layer (12) is chosen strictly less than the thickness of the fourth layer (22).

3. Method according to any one of the preceding claims, wherein the thickness of the first layer (11) is chosen strictly less than the thickness of the second layer (12), and wherein the thickness of the third layer (21) is chosen strictly less than the thickness of the fourth layer (22).

4. Method according to claim 1, wherein the thickness of the first layer (11) is chosen strictly less than the thickness of the third layer (21), and wherein the thickness of the second layer (12) is chosen strictly less than the thickness of the fourth layer (22), and wherein the thickness of the first layer (11) is chosen strictly less than the thickness of the second layer (12), and wherein the thickness of the third layer (21) is chosen strictly less than the thickness of the fourth layer (22).

5. Method according to any one of the preceding claims, wherein the support (30) is partially removed by cropping, said cropping being configured to leave a residual layer of the support (30) having a residual thickness less than or equal to 50µm.

6. Method according to the preceding claim, wherein the residual layer is removed by a first etching have a selectivity regarding the fourth material greater than 5.

7. Method according to the preceding claim, wherein the first etching and the etching of the third layer (21) are etchings in solution having one same composition.

8. Method according to any one of the preceding claims, wherein the etching of the fourth layer (22) and the etching of the second layer (12) are etchings in solution having one same composition.

9. Method according to any one of the preceding claims, wherein the thickness of the second layer (12) is less than or equal to 100nm.

10. Method according to any one of the preceding claims, wherein the thickness of the first layer (11) is less than 50nm.

11. Method according to any one of the preceding claims, wherein the polymer material is a thermoplastic material and/or the first and third materials are at least one from among silicon, germanium and a silicon-germanium alloy, and/or the second and fourth materials are at least one from among a silicon oxide and a silicon nitride.

12. Method according to any one of the preceding claims, wherein the support (30) is made of silicon, the first and third materials are only silicon and the second and fourth materials are only a silicon oxide.
